# EUROPÄISCHE PATENTANMELDUNG

(11) **EP 3 131 378 A1**
(43) Veröffentlichungstag der Anmeldung: **15.02.2017**
(21) Anmeldenummer: 16184137.4
(22) Anmeldetag: 15.08.2016
(51) Int. Cl.: H05K 7/20, G06F 1/20

(54) **ROHRLEITUNGSDURCHFÜHRUNG IN EINEM SCHRANK FÜR ELEKTRONISCHE KOMPONENTEN**

(30) Priorität: 14.08.2015 DE 102015215558
(71) Anmelder: Schäfer Werke GmbH, 57290 Neunkirchen (DE)
(72) Erfinder: TREPTE, Wolfgang, 01665 Diera-Zehren (DE); BAUMANN, Jörg, 65620 Waldbrunn 5 (DE)
(74) Vertreter: Grosse, Wolf-Dietrich Rüdiger

(57) **Zusammenfassung**

Vorrichtung (1) mit einem Gehäuse (10), einer oder mehreren darin aufgenommenen elektronischen Komponenten (20) und einer Kühlung (30), die eine Zuleitung (31) zum Einbringen eines Kältemittels in das Gehäuse (10) und eine Ableitung (32) zum Abführen des Kältemittels aus dem Gehäuse (10) aufweist, dadurch gekennzeichnet, dass die Zuleitung (31) an einer Leitungsdurchführung (11) in das Gehäuse (10) eintritt, die Ableitung (32) an der Leitungsdurchführung (11) aus dem Gehäuse (10) austritt und im Bereich der Leitungsdurchführung (11) die Zuleitung (31) in der Ableitung (32) oder die Ableitung (32) in der Zuleitung (31) vorgesehen ist.

## Beschreibung

### Technisches Gebiet

Die Erfindung betrifft eine Vorrichtung mit einem Gehäuse, einer oder mehreren darin aufgenommenen elektronischen Komponenten und einer Kühlung, die eine Zuleitung zum Einbringen eines Kältemittels in das Gehäuse und eine Ableitung zum Abführen des Kältemittels aus dem Gehäuse aufweist.

### Hintergrund der Erfindung

Elektronische Komponenten für die Datenverarbeitung erfordern eine Kühlung, die mit steigender Rechenleistung für immer höhere Wärmelasten ausgelegt sein muss. Wenn die reine Luftkühlung mittels Konvektion der Umgebungsluft an ihre Grenzen stößt, besteht eine Möglichkeit zur Steigerung der Kühlleistung darin, eine Luft-Kältemittel-Kühlung anzuwenden. Eine solche Kühlung wird in Schränken für IT-Komponenten, beispielsweise Serverschränken oder Schaltschränken, eingesetzt.

Die DE 10 2012 112 507 B3 beschreibt eine derartige Vorrichtung mit einer Kühlung, die ein umlaufendes Kältemittel verwendet. Es ist ein Schaltschrank beschrieben, der ein Gehäuse und einen daran schwenkbar angebrachten Wärmetauscher hat. Ferner sind eine Vorlaufleitung und eine Rücklaufleitung für das Kältemittel vorgesehen, wobei beide Leitungen über Durchlässe in einer vertikalen Seitenwand aus dem Wärmetauscher herausgeführt werden. Ein weiteres elektronisches Gerät mit Luft-Kältemittel-Kühlung geht aus der DE 41 25 528 C2 hervor.

Als Kältemittel kommt beispielsweise eines auf Basis von Wasser in Frage. Solche Luft-Wasser-Wärmetauscher arbeiten wasserseitig mit einer kleinen Temperaturdifferenz, was relativ große Rohrleitungsquerschnitte erforderlich macht, um einen ausreichenden Volumenstrom des Kältemittels zu ermöglichen. Dadurch nehmen die Komponenten der Kühlung erheblichen Platz ein, der dann den elektronischen Komponenten nicht zur Verfügung steht. Weiterer Bauraum geht für Anschlüsse an weiterführende Kühlwasserleitungen innerhalb und außerhalb des IT-Schranks verloren. Da die IT-Komponenten selbst luftgekühlt sind, tritt an den Rohrleitungen für das Kühlwasser ein zusätzlicher Druckverlust für die Kühlluft auf.

Ein weiteres Problem der Luft-Wasser-Kühlung besteht darin, dass Luft in der Umgebung der Rohrleitungsdurchführungen des IT-Schranks kondensiert. Das Kondenswasser setzt sich dort an schwer zugänglichen Stellen ab und kann zu Schäden am Schrank, den Rohrleitungskomponenten oder elektronischen Komponenten führen. Eine Isolierung der Rohrleitungen erfordert weiteren Bauraum und ist oft aufgrund eines kleinen Abstands zwischen den Leitungen schwierig.

### Darstellung der Erfindung

Eine Aufgabe der Erfindung besteht darin, eine Vorrichtung mit einer oder mehreren elektronischen Komponenten, insbesondere einen Schrank mit IT-Komponenten, bereitzustellen, die bei hoher Betriebssicherheit und Beständigkeit eine effektive Kühlung mit minimalem Platzbedarf für die Kühlkomponenten ermöglicht.

Gelöst wird die Aufgabe mit einer Vorrichtung mit den Merkmalen des Anspruchs 1. Vorteilhafte Weiterbildungen folgen aus den Unteransprüchen, der folgenden Darstellung der Erfindung sowie der Beschreibung bevorzugter Ausführungsbeispiele.

Die erfindungsgemäße Vorrichtung hat ein Gehäuse, ein oder mehrere darin aufgenommene elektronische Komponenten und eine Kühlung. Besonders bevorzugt handelt es sich bei der Vorrichtung um einen IT-Schrank, d.h. einen Schrank für elektronische Komponenten zur Datenverarbeitung, wie etwa Prozessoren, Speichereinrichtungen, Platinen, Akkus usw.. Die Kühlung, vorzugsweise eine Luft-Kältemittel-Kühlung, dient zum Abführen der von den elektronischen Komponenten erzeugten Wärme aus dem Gehäuse. Dazu weist die Kühlung eine Zuleitung zum Einbringen eines Kältemittels in das Gehäuse und eine Ableitung zum Abführen des Kältemittels aus dem Gehäuse auf. Die Zuleitung und/oder Ableitung können teilweise oder vollständig als Rohr und/oder Schlauch ausgeführt sein. Vorzugsweise sind die Zuleitung und/oder die Ableitung zumindest teilweise als Stahlrohr oder Kupferrohr gefertigt. Die Zuleitung und die Ableitung sind im Gehäuse vorzugsweise mit einem Wärmeübertrager verbunden, der zum Kühlen von Luft im Inneren des Gehäuses vorgesehen ist. Der Wärmeübertrager ist vorzugsweise aus Kupfer und/oder Aluminium gefertigt, weist vorzugsweise Lamellen auf und ist vorzugweise einfach ausbaubar, für Wartungsarbeiten oder eine eventuelle Reparatur. Das Gehäuse selbst kann aus Metall, Kunststoff, Glas und/oder mittels anderer Materialien gefertigt sein, es kann zur äußeren Umgebung hermetisch abgeschlossen oder auch teilweise offen oder zu öffnen sein. Vorzugsweise weist das Gehäuse einen Stahlrahmen auf. Es können eine oder mehrere Türen vorgesehen sein. Unterhalb des Wärmeübertragers kann eine Kondensatwanne, etwa aus Edelstahl, vorgesehen sein, um Kondenswasser aufzufangen. Ferner kann das Gehäuse einen Doppelboden aufweisen, etwa zur Führung von Rohrleitungen, Kabel usw., und/oder es können ein oder mehrere Ventilatoren vorgesehen sein, um die Luftzirkulation im Inneren des Gehäuses zu optimieren.

Die Zuleitung tritt an einer Leitungsdurchführung, die eine Öffnung in dem Gehäuse ist, in das Gehäuse ein, die Ableitung tritt an derselben Leitungsdurchführung aus dem Gehäuse aus. Erfindungsgemäß ist im Bereich der Leitungsdurchführung die Zuleitung in der Ableitung oder die Ableitung in der Zuleitung vorgesehen. In anderen Worten: im Bereich der Leitungsdurchführung werden die beiden Leitungen "Rohr-in-Rohr" geführt. Der Bereich der Leitungsdurchführung umfasst zumindest die Gehäusedicke an dieser Stelle, d.h. dem Abschnitt, an dem die Leitungen durch die Gehäusewand geführt werden, vorzugsweise sind aber auch Abschnitte innerhalb und außerhalb des Gehäuses, unmittelbar im Anschluss an die Leitungsdurchführung umfasst. So ist die Bezeichnung "Bereich der Leitungsdurchführung" zu verstehen.

Indem im Bereich der Leitungsdurchführung die Zuleitung innerhalb der Ableitung oder die Ableitung innerhalb der Zuleitung vorgesehen ist, wird Bauraum eingespart, der etwa den elektronischen Komponenten zugutekommt. Darüber hinaus isoliert die äußere Leitung die innere Leitung, wodurch die Raumersparnis und die Isolation auf synergetische Weise miteinander kombiniert werden. Auf eine zusätzliche Isolation kann gegebenenfalls verzichtet werden. Insbesondere können die beiden Leitungen dünnwandig ausgeführt werden.

Eine weitere technische Wirkung der hier dargestellten Lösung besteht darin, dass die Bildung von Kondenswasser reduziert, zumindest aber an eine Stelle verschoben wird, die tendenziell weiter im Inneren des Gehäuses liegt, als im Fall getrennter Zu- und Ableitung. Das ist insbesondere dann der Fall, wenn die Zuleitung in der Ableitung vorgesehen ist, d.h. das zulaufende Kältemittel vom wärmeren ablaufenden Kältemittel umspült wird. Denn dann isoliert der warme Ablaufstrom den kalten Zulaufstrom, der beim Eintritt ins Gehäuse somit nicht unmittelbar auf die warme Atmosphäre im Inneren des Gehäuses trifft. Die Bildung von Kondenswasser wird verringert und weiter ins Innere verschoben, wo es einfacher und kontrollierter abgeführt werden kann. Damit wird das Gehäuse im Bereich der Leitungsdurchführung vor Kondenswasser geschützt, wodurch die Betriebssicherheit der Vorrichtung verbessert wird.

Die Kühlung ist wie erwähnt vorzugsweise eine Luft-Kältemittel-Kühlung, besonders bevorzugt eine Luft-Wasser-Kühlung, wobei die Zuleitung zum Einbringen von Kalt-Kältemittel bzw. Kaltwasser in das Gehäuse und die Ableitung zum Abführen von Warm-Kältemittel bzw. Warmwasser aus dem Gehäuse vorgesehen sind. Mit der Bezeichnung "Luft-Wasser-Kühlung" ist jedwede Kühlung umfasst, deren Kältemittel Wasser als Hauptbestandteil hat. Bevorzugt kommt hier ein Wasser/Glykol-Gemisch zum Einsatz, etwa mit einem Glykolanteil von 35%. Damit wird eine effektive und kostengünstige Kühlung, die ohne Spezialkältemittel auskommt, bereitgestellt.

Die Zuleitung und/oder die Ableitung sind vorzugsweise luftdicht in der Leitungsdurchführung vorgesehen, so dass keine Luft zwischen dem Inneren und Äußeren des Gehäuses durch die Leitungsdurchführung ausgetauscht werden kann. In anderen Worten: an der Leitungsdurchführung liegt eine luftdichte Abschottung zum Gehäuseinneren vor. Damit wird verhindert, dass Feuchtigkeit und Luft an der Leitungsdurchführung Schäden, wie etwa Korrosion, verursachen. Mit der vorliegenden Erfindung lässt sich die luftdichte Abschottung besonders einfach und dauerhaft realisieren, da das Gehäuse nur gegen den äußeren Querschnitt der beiden Leitungen abgedichtet werden muss.

Die Temperaturdifferenz zwischen dem Kältemittel in der Zuleitung und dem Kältemittel in der Ableitung beträgt vorzugsweise maximal 8 K, liegt besonders bevorzugt zwischen 2 und 6 K. Konkret kann der Wärmeübertrager so ausgelegt sein, dass im stationären Zustand 15°C auf der Kaltseite und 21°C auf der Warmseite anliegen. Eine effektive Kühlung bei kleinen Kältemittel-Temperaturdifferenzen erfordert einen großen Leitungsquerschnitt, der sich mittels der Rohr-in-Rohr-Lösung ausgezeichnet realisieren lässt. Im Falle eines kreisförmigen Querschnitts der Zuleitung und der Ableitung, die vorzugsweise konzentrisch zueinander liegen, ist das Verhältnis aus Strömungsquerschnitt und Platzbedarf optimal.

Vorzugsweise weist die Zuleitung und/oder Ableitung ein oder mehrere Drehgelenke auf. Besonders bevorzugt weist die äußere der beiden Leitungen im Inneren des Gehäuses ein oder mehrere Drehgelenke auf. Damit lässt sich die Kühlung einfach an die Wärmeverteilung im Inneren des Gehäuses anpassen, die Montage vereinfacht sich und die Haltbarkeit und Zuverlässigkeit werden verbessert, da den Komponenten der Kühlung durch die Gelenke ein Spielraum bereitgestellt wird, etwa zur Kompensation thermischer Expansion.

Vorzugsweise ist der Abschnitt, in dem die Zuleitung in der Ableitung oder die Ableitung in der Zuleitung geführt wird, kürzer als diejenige Länge, mit der die Zuleitung und/oder Ableitung im Inneren des Gehäuses getrennt geführt werden. Damit soll zum Ausdruck gebracht werden, dass der Rohr-in-Rohr-Abschnitt vorzugsweise kurz ausgeführt ist, beispielsweise nur wenig länger als die Leitungsdurchführung ist.

Wenngleich die Erfindung besonders bevorzugt im Bereich von IT-Schränken zur Anwendung kommt, eignet sie sich auch für andere elektronische Einrichtungen, die ein Gehäuse und darin aufgenommene elektronische Komponenten, die eine effektive Kühlung erfordern, aufweisen. Weitere Vorteile und Merkmale der vorliegenden Erfindung sind aus der folgenden Beschreibung bevorzugter Ausführungsbeispiele ersichtlich. Die dort beschriebenen Merkmale können alleinstehend oder in Kombination mit einem oder mehreren der oben dargelegten Merkmale umgesetzt werden, insofern sich die Merkmale nicht widersprechen. Die folgende Beschreibung der bevorzugten Ausführungsbeispiele erfolgt dabei unter Bezugnahme auf die begleitenden Zeichnungen.

### Kurze Beschreibung der Figuren

Figur 1 zeigt schematisch einen Querschnitt durch einen IT-Schrank mit einem Gehäuse, darin aufgenommenen elektronischen Komponenten und einer Luft-Wasser-Kühlung.
Figur 2 zeigt ein weiteres Ausführungsbeispiel für einen IT-Schrank mit einem Gehäuse, darin aufgenommenen elektronischen Komponenten und einer Luft-Wasser-Kühlung.

### Detaillierte Beschreibung bevorzugter Ausführungsbeispiele

Im Folgenden werden bevorzugte Ausführungsbeispiele anhand der Figuren beschrieben. Dabei sind gleiche, ähnliche oder gleichwirkende Elemente in den Figuren mit identischen Bezugszeichen versehen, und auf eine wiederholende Beschreibung dieser Elemente wird teilweise verzichtet, um Redundanzen zu vermeiden.

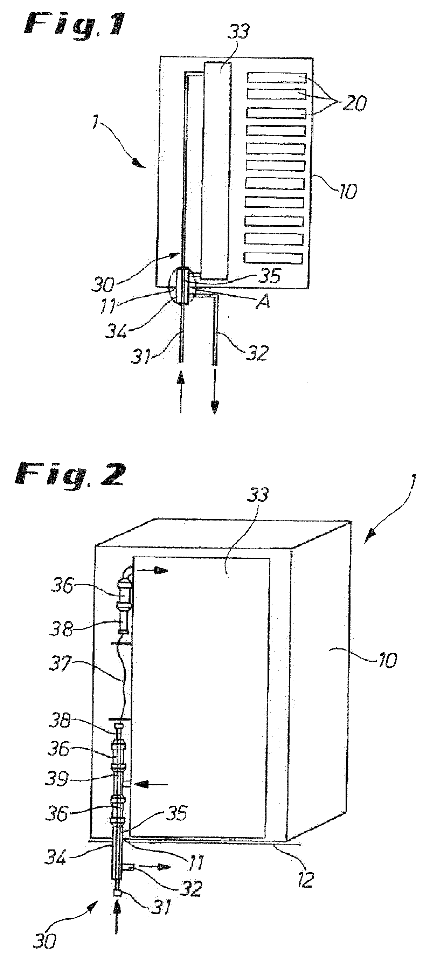

Die Figur 1 zeigt schematisch einen Querschnitt durch eine Vorrichtung 1, konkret einen IT-Schrank, mit einem Gehäuse 10, darin aufgenommenen elektronischen Komponenten 20 und einer Luft-Wasser-Kühlung 30. Die elektronischen Komponenten 20 umfassen etwa Prozessoren, Speichereinrichtungen, integrierte Schaltkreise, Akkumulatoren und andere Komponenten, die bei der elektronischen Datenverarbeitung Anwendung finden, Wärme abstrahlen und vor einer Überhitzung durch eine geeignete Kühlung geschützt werden müssen. Die Luft-Wasser-Kühlung 30 dient zum Abführen der von den elektronischen Komponenten 20 erzeugten Wärme aus dem Gehäuse 10. Dazu weist die Kühlung 30 eine Zuleitung 31 zum Einbringen von Kaltwasser in das Gehäuse 10 und eine Ableitung 32 zum Abführen von Warmwasser aus dem Gehäuse 10 auf. Die Zuleitung 31 und die Ableitung 32 sind als Rohre und/oder Schläuche, beispielsweise aus Kupfer oder Stahl, ausgeführt. Die Zuleitung 31 und die Ableitung 32 sind im Gehäuse 10 mit einem Wärmeübertrager 33 verbunden, der zum Kühlen von Luft im Inneren des Gehäuses 10 vorgesehen ist. Das Gehäuse 10 selbst kann aus Metall, Kunststoff, Glas und/oder mittels anderer Materialien gefertigt sein, es kann zur äußeren Umgebung hermetisch abgeschlossen oder auch teilweise offen oder zu öffnen sein. Vorzugsweise weist das Gehäuse einen Stahlrahmen auf. Es können eine oder mehrere Türen vorgesehen sein. Unterhalb des Wärmeübertragers kann eine Kondensatwanne, etwa aus Edelstahl, vorgesehen sein, um Kondenswasser aufzufangen.

Um die von den elektronischen Komponenten 30 erzeugte Wärme aus dem Gehäuse 10 zu transportieren, wird Kaltwasser (analog ein Kaltwassergemisch oder ein anderes Kältemittel) von außen über die Zuleitung 31 zugeführt und durchläuft den Wärmeübertrager 33, wo wenigstens ein Teil der Wärme an das Kältemittel übertragen wird. Der Wärmeübertrager kann als Plattenwärmetauscher, Spiralwärmetauscher, aus Metall, Emaille, Kunststoff oder auf andere Weise vorgesehen sein, solange er eine Übertragung der Wärme im Inneren des Gehäuses 10 an das Kältemittel ermöglicht. Das auf diese Weise erwärmte Kältemittel wird über die Ableitung 32 aus dem Gehäuse 10 abtransportiert.

Sowohl die Zuleitung 31 als auch die Ableitung 32 treten an einer Leitungsdurchführung 11, die eine Öffnung in dem Gehäuse 10 ist, von außen in das Gehäuseinnere ein. Im Bereich A der Leitungsdurchführung ist die Zuleitung 31 im Inneren der Ableitung 32 vorgesehen. In anderen Worten: die Zuleitung 31 und die Ableitung 32 werden durch eine platzsparende Rohr-in-Rohr-Konstruktion miteinander verbunden, d.h. Kaltwasser und Warmwasser werden in einem gemeinsamen Rohr 34 durch die Gehäusewand geführt, wobei die beiden Fluide durch eine Trennwand 35 voneinander getrennt sind. Im Bereich A der Leitungsdurchführung werden die beiden Leitungen 31, 32 Rohr-in-Rohr geführt.

Der Bereich A der Leitungsdurchführung umfasst zumindest die Gehäusedicke an dieser Stelle, d.h. dem Abschnitt, an dem die Leitungen durch die Gehäusewand geführt werden, vorzugsweise sind aber auch Abschnitte innerhalb und außerhalb des Gehäuses 10, unmittelbar im Anschluss an die Leitungsdurchführung 11 umfasst. Außerhalb des IT-Schranks 1 sind die Zuleitung 31 und die Ableitung 32 beispielsweise an eine nicht dargestellte Gebäudekühlanlage angeschlossen.

Das gemeinsame Rohr 34 ist luftdicht in der Leitungsdurchführung 11 vorgesehen, so dass keine Luft zwischen dem Inneren und Äußeren des Gehäuses 10 durch die Leitungsdurchführung 11 ausgetauscht werden kann.

Ein weiteres Ausführungsbeispiel ist in der Figur 2 gezeigt. Darin wird die innere Rohrleitung, die Zuleitung 31, durch mehrere Drehgelenke 36, die von dem Kühlwasser durchflossen werden, geführt. Damit lässt sich die Anordnung der Kühlkomponenten, wie Schläuche, Rohre, Wärmeübertrager, einfach und modular an die Wärmeverteilung im Inneren des Gehäuses anpassen, die Montage vereinfacht sich und die Haltbarkeit wird verbessert. Weiter flexibilisieren lässt sich das Kühlsystem, indem - wie in Figur 2 gezeigt - der Kaltwasservorlauf innerhalb des Gehäuses 10 teilweise von einem Flexschlauch 37 übernommen wird. Der Flexschlauch 37 ist mittels zweier Verbindungsstücke 38 für den Kaltwasservorlauf an die Zuleitung 31, bzw. entsprechende Drehgelenke 36, angebunden. Ein Verbindungsstück 39 führt das Warmwasser in den Rohr-in-Rohr-Abschnitt zurück. Nichtsdestotrotz sollen so wenig wie mögliche Schraubverbindungen vorgesehen sein, um Leckage zu vermeiden.

Das Gehäuse 10 weist im Ausführungsbeispiel der Figur 2 einen Doppelboden 12 auf, zur Führung von Rohrleitungen, Kabel usw.. Zu diesem Zweck befinden sich zudem vorzugsweise ein oder mehrere Ventilatoren im Bereich der Luft-Wasser-Kühlung 30.

Indem im Bereich A der Leitungsdurchführung die Zuleitung 31 innerhalb der Ableitung 32 geführt wird, wird Bauraum eingespart, der den elektronischen Komponenten 20 zugutekommen kann. Für den Kaltwasservorlauf und den Warmwasserrücklauf ist an der Leitungsdurchführung 11 ein vergleichsweise geringer Flächenquerschnitt erforderlich. Darüber hinaus isoliert die Ableitung 32 die Zuleitung 31, wodurch die Raumersparnis und die Isolation auf synergetische Weise miteinander kombiniert werden. Beide Leitungen 31, 32 können dünnwandig ausgeführt werden. Ferner verringert sich die Bildung von Kondenswasser und wird tendenziell ins Gehäuseinnere verschoben. Denn der Warmwasserrücklauf isoliert den Kaltwasservorlauf, der beim Eintritt ins Gehäuse 10 somit nicht unmittelbar auf die warme Atmosphäre im Inneren des Gehäuses 10 trifft. Das Kondenswasser kann kontrolliert abgeführt werden.

Wenngleich die hier dargelegten Ausführungsbeispiele den bevorzugten Fall zeigen, in dem die Ableitung 32 die Zuleitung 31 umgibt, können der Kaltwasservorlauf und der Warmwasserrücklauf gegebenenfalls im Rohr-in-Rohr-Abschnitt umgekehrt verlaufen, sodass die Zuleitung 31 die Ableitung 32 umgibt. Ferner ist es nicht unbedingt erforderlich, dass die überschüssige Wärme im Inneren des Gehäuses 10 mittels Wasser oder eines Wasser/Glykol-Gemischs abtransportiert wird. Ein anderes, geeignetes Kältemittel kann ebenfalls angewendet werden.

Soweit anwendbar, können alle einzelnen Merkmale, die in den Ausführungsbeispielen dargestellt sind, miteinander kombiniert und/oder ausgetauscht werden, ohne den Bereich der Erfindung zu verlassen.

### Bezugszeichenliste

- 1: IT-Schrank
- 10: Gehäuse
- 11: Leitungsdurchführung
- 12: Doppelboden
- 20: elektronische Komponenten
- 30: Luft-Wasser-Kühlung
- 31: Zuleitung
- 32: Ableitung
- 33: Wärmeübertrager
- 34: gemeinsames Rohr
- 35: Trennwand
- 36: Drehgelenk
- 37: Flexschlauch
- 38: Verbindungsstücke für den Kaltwasservorlauf
- 39: Verbindungsstück für den Warmwasserrücklauf
- A: Bereich der Leitungsdurchführung

## Patentansprüche

1. Vorrichtung (1) mit einem Gehäuse (10), einer oder mehreren darin aufgenommenen elektronischen Komponenten (20) und einer Kühlung (30), die eine Zuleitung (31) zum Einbringen eines Kältemittels in das Gehäuse (10) und eine Ableitung (32) zum Abführen des Kältemittels aus dem Gehäuse (10) aufweist,
**dadurch gekennzeichnet, dass**
die Zuleitung (31) an einer Leitungsdurchführung (11) in das Gehäuse (10) eintritt, die Ableitung (32) an der Leitungsdurchführung (11) aus dem Gehäuse (10) austritt und im Bereich der Leitungsdurchführung (11) die Zuleitung (31) in der Ableitung (32) oder die Ableitung (32) in der Zuleitung (31) vorgesehen ist.

2. Vorrichtung (1) nach Anspruch 1, **dadurch gekennzeichnet, dass** die Kühlung (30) eine Luft-Kältemittel-Kühlung, vorzugsweise eine Luft-Wasser-Kühlung, ist, wobei die Zuleitung (31) zum Einbringen von Kalt-Kältemittel in das Gehäuse (10) und die Ableitung (32) zum Abführen von Warm-Kältemittel aus dem Gehäuse (10) vorgesehen sind.

3. Vorrichtung (1) nach Anspruch 1 oder 2, **dadurch gekennzeichnet, dass** die Zuleitung (31) und die Ableitung (32) im Gehäuse (10) mit einem Wärmeübertrager (33) verbunden sind, der zum Kühlen von Luft im Inneren des Gehäuses (10) vorgesehen ist.

4. Vorrichtung (1) nach einem der vorhergehenden Ansprüche, **dadurch gekennzeichnet, dass** die Zuleitung (31) und/oder die Ableitung (32) luftdicht in der Leitungsdurchführung (11) vorgesehen sind, so dass keine Luft zwischen dem Inneren und Äußeren des Gehäuses (10) durch die Leitungsdurchführung (11) ausgetauscht werden kann.

5. Vorrichtung (1) nach einem der vorhergehenden Ansprüche, **dadurch gekennzeichnet, dass** die Temperaturdifferenz zwischen dem Kältemittel in der Zuleitung (31) und dem Kältemittel in der Ableitung (32) maximal 8 K beträgt, vorzugsweise zwischen 2 und 6 K liegt.

6. Vorrichtung (1) nach einem der vorhergehenden Ansprüche, **dadurch gekennzeichnet, dass** die Zuleitung (31) und die Ableitung (32) jeweils einen kreisförmigen Querschnitt haben und im Bereich der Leitungsdurchführung (11) konzentrisch zueinander angeordnet sind.

7. Vorrichtung (1) nach einem der vorhergehenden Ansprüche, **dadurch gekennzeichnet, dass** die Zuleitung (31) und/oder Ableitung (32) ein oder mehrere Drehgelenke (36) aufweisen.

8. Vorrichtung (1) nach Anspruch 7, **dadurch gekennzeichnet, dass** die äußere der beiden Leitungen (31, 32) im Inneren des Gehäuses (10) ein oder mehrere Drehgelenke (36) aufweist.

9. Vorrichtung (1) nach einem der vorhergehenden Ansprüche, **dadurch gekennzeichnet, dass** der Abschnitt, in dem die Zuleitung (31) in der Ableitung (32) oder die Ableitung (32) in der Zuleitung (31) geführt wird, kürzer als diejenige Länge ist, mit der die Zuleitung (31) und/oder Ableitung (32) im Inneren des Gehäuses (10) getrennt geführt werden.

10. Vorrichtung (1) nach einem der vorhergehenden Ansprüche, **dadurch gekennzeichnet, dass** im Bereich der Leitungsdurchführung (11) die Zuleitung (31) in der Ableitung (32) vorgesehen ist.

11. Vorrichtung (1) nach einem der vorhergehenden Ansprüche, **dadurch gekennzeichnet, dass** die Zuleitung (31) und/oder die Ableitung (32) zumindest im Bereich der Leitungsdurchführung (11) aus Stahl oder Kupfer gefertigt sind.
